# EUROPEAN PATENT APPLICATION

(11) **EP 4 404 243 A1**
(43) Date of publication of application: **24.07.2024**
(21) Application number: 22869883.3
(22) Date of filing: 08.09.2022
(51) Int. Cl.: H01L 21/304

(54) **SUBSTRATE PRODUCTION METHOD AND SUBLIMATION DRYING METHOD**

(30) Priority: 15.09.2021 JP 2021150186
(71) Applicant: Central Glass Company, Limited, Ube-shi, Yamaguchi 755-0001 (JP)
(72) Inventor: TERUI, Yoshiharu, Ube-shi, Yamaguchi 755-0001 (JP); YOSHIDA, Ayaka, Ube-shi, Yamaguchi 755-0001 (JP)
(74) Representative: Mewburn Ellis LLP
(86) International application number: PCT/JP2022/033662
(87) International publication number: WO 2023/042736

(57) **Abstract**

The method for producing a substrate of the present invention includes a preparation step of preparing a substrate that has an uneven structure at the surface thereof, an arrangement step of arranging the substrate in a chamber with a cleaning liquid held in at least recessed portions of the uneven structure, a supply step of supplying a sublimable substance in a liquid state or supplying a sublimable film formation composition in a liquid state that includes a sublimable substance to at least the recessed portions of the substrate arranged in the chamber, and a sublimation drying step of coagulating, sublimating, and thereby removing a film of the sublimable substance or sublimable film formation composition that has been supplied, the sublimation drying step is controlled such that T_{dp} and Tₘᵢₙ satisfy Tₘᵢₙ > T_{dp}.

## Description

### TECHNICAL FIELD

The present invention relates to a method for producing a substrate and a sublimation drying method.

### BACKGROUND ART

The sublimation drying method is one of drying methods employed in a step of cleaning fine semiconductor structures, that is, patterns. The sublimation drying method is used to suppress pattern collapse by forming a film formed of a sublimable substance on a pattern formed on a substrate surface and removing the film by volatilization.

Patent Document 1 describes a technique related to the sublimation drying method described above. Patent Document 1 describes a substrate drying method for drying a substrate by removing a liquid on the substrate on the surface of which an uneven pattern is formed, the method being provided with a sublimable substance filling step of supplying a sublimable substance solution to the substrate to fill the solution in recessed portions of the pattern, a solvent drying step of drying the solvent in the solution and filling the inside of the recessed portions of the pattern with the sublimable substance in a solid state, and a sublimable substance removal step of removing the sublimable substance from the substrate by heating the substrate to a temperature higher than the sublimation temperature of the sublimable substance (claim 1 of Patent Document 1).

### RELATED DOCUMENT

### PATENT DOCUMENT

Patent Document 1: Japanese Unexamined Patent Publication No. 2012-243869

### SUMMARY OF THE INVENTION

### TECHNICAL PROBLEM

However, as a result of investigation by the present inventors, it was found that, in the sublimation drying method described in Patent Document 1 described above, there is room for improvement in terms of the stability in suppressing pattern collapse.

### SOLUTION TO PROBLEM

While continuing to study the sublimation drying method described above, when test pieces on which a pattern was formed using a composition for forming a sublimable film of the same composition (may be described below as a "sublimable film formation composition") were subjected to sublimation drying, it was found that it may be difficult to find reproducibility or trends relating to whether or not it is possible to suppress pattern collapse and to the degree of suppression. Specifically, when attempting to suppress pattern collapse using a sublimable film formation composition, results in which it was possible to suppress pattern collapse over almost the entire surface of the test pieces, results in which it was not possible to suppress pattern collapse, and results in which regions in which it was possible to suppress pattern collapse and regions in which the suppression was insufficient were mixed on a scale of micrometers to millimeters were obtained in a disorderly manner for each test example.

As a result of further investigation, it was found that, after a sublimable film formation composition is supplied onto a wafer, the dew point of the atmosphere that comes into contact with the surface of the formed coating film tends to exert an influence thereon. When the dew point temperature of the atmosphere is high, it is presumed that, in the coating film surface, the moisture included in the atmosphere will be absorbed on the entire surface of the coating film or locally, or that the moisture will condense on the entire surface of the coating film or locally. In addition, particularly in a case where the sublimable film formation composition contains a solvent, it is presumed that heat is lost from the coating film or the wafer due to the heat of vaporization during volatilization of the solvent, making dew condensation likely to occur. As described above, it is considered that moisture absorbed into the coating film and dew condensation on the coating film surface inhibit the formation of the sublimable film obtained by coagulating the coating film, causing coagulation defects in the sublimable film, resulting in it not being possible to suppress pattern collapse either on the entire surface or locally and making it difficult to find reproducibility or trends.

As a result of a study based on the findings obtained above, in the coagulation process of a film formed of a sublimable substance or a sublimable film formation composition, it was discovered that controlling the dew point temperature (T_{dp}) at 1 atm of the atmosphere in the chamber in which the film is arranged to be lower than a minimum temperature (Tₘᵢₙ) of the surface temperature of the film makes it possible to stably suppress pattern collapse in a method for producing a substrate using a sublimation drying method, thereby completing the present invention.

According to one aspect of the present invention, the method for producing a substrate and the sublimation drying method below are provided.
1. A method for producing a substrate, the method including a preparation step of preparing a substrate that has an uneven structure on a surface, an arrangement step of arranging the substrate in a chamber with a cleaning liquid held in at least recessed portions of the uneven structure, a supply step of supplying a sublimable substance in a liquid state or supplying a sublimable film formation composition in a liquid state that includes a sublimable substance to at least the recessed portions of the substrate arranged in the chamber, and a sublimation drying step of coagulating, sublimating, and thereby removing a film formed of the sublimable substance or the sublimable film formation composition that has been supplied, in which, when a dew point temperature of an atmosphere inside the chamber at 1 atm is T_{dp}°C and a minimum temperature of a surface of the film during a coagulation process is Tₘᵢₙ°C, the sublimation drying step is controlled such that T_{dp} and Tₘᵢₙ satisfy Tₘᵢₙ > T_{dp}.
2. The method for producing a substrate according to 1, in which the sublimation drying step is controlled such that T_{dp} and Tₘᵢₙ satisfy Tₘᵢₙ-T_{dp} ≥ 20.
3. The method for producing a substrate according to 1 or 2, in which, when a final surface temperature of the film during the coagulation process, in which the surface temperature increases after reaching the minimum temperature and stops increasing, is Tᵤₚ°C, the sublimation drying step is controlled such that T_{dp} and Tᵤₚ satisfy Tᵤₚ > T_{dp}.
4. The method for producing a substrate according to any one of 1 to 3, the method further including one or two or more treatments selected from the group consisting of a treatment for supplying a dry gas into an interior of the chamber or replacing a gas in the interior of the chamber with the dry gas in a step before the supply step, a treatment for bringing the dry gas into contact with the surface of the film in the sublimation drying step, and a treatment for heating the substrate in the sublimation drying step.
5. The method for producing a substrate according to any one of 1 to 4, in which the sublimation drying step includes, at least during the coagulation process of the film, a treatment for supplying a dry gas into an interior of the chamber and discharging a gas in the interior of the chamber.
6. The method for producing a substrate according to 4 or 5, in which the dry gas includes a dry inert gas.
7. The method for producing a substrate according to any one of 1 to 6, in which the sublimable film formation composition is supplied in the supply step and the sublimable film formation composition includes the sublimable substance and a solvent.
8. The method for producing a substrate according to 7, in which the sublimable film formation composition includes a solvent A1 for which a saturation solubility of the sublimable substance is more than 10% by mass and which has a boiling point lower than a boiling point of the sublimable substance at 1 atm by 5°C or more.
9. The method for producing a substrate according to 7, in which the sublimable film formation composition includes a solvent A2 for which a saturation solubility of the sublimable substance is more than 10% by mass, and a solvent B2 for which a content in the sublimable film formation composition is greater than a content of the solvent A2 and which has a boiling point lower than a boiling point of the sublimable substance at 1 atm and lower than a boiling point of the solvent A2.
10. The method for producing a substrate according to any one of 1 to 9, in which a coagulation heat of the sublimable substance is 200 J/g or less.
11. The method for producing a substrate according to any one of 1 to 10, in which the cleaning liquid includes an alcohol with 3 or fewer carbon atoms.
12. The method for producing a substrate according to any one of 1 to 11, in which the substrate has the uneven structure having a pattern dimension of 30 nm or less on the surface.
13. The method for producing a substrate according to 12, in which the substrate has the uneven structure having the pattern dimension of 20 nm or less on the surface.
14. The method for producing a substrate according to any one of 1 to 13, in which the sublimable film formation composition does not contain water or contains a water content of 10% by mass or less with respect to 100% by mass of the sublimable substance.
15. A sublimation drying method including a sublimation drying step of coagulating, sublimating, and thereby removing a film formed of a sublimable substance or a sublimable film formation composition including a sublimable substance, in which, when a dew point temperature of an atmosphere in a vicinity of the film at 1 atm is T_{dp}°C and a minimum temperature of a surface of the film during a coagulation process is Tₘᵢₙ°C, the sublimation drying step is controlled such that T_{dp} and Tₘᵢₙ satisfy Tₘᵢₙ > T_{dp}.

### ADVANTAGEOUS EFFECTS OF INVENTION

According to the present invention, there is provided a method for producing a substrate that has excellent stability in suppressing pattern collapse during sublimation drying and a sublimation drying method.

### BRIEF DESCRIPTION OF THE DRAWINGS

Fig. 1 is a step cross-sectional view schematically showing an example of the production steps of a substrate according to the present embodiment.
Fig. 2 is a cross-sectional view schematically showing an example of a substrate processing apparatus.

### DESCRIPTION OF EMBODIMENTS

A description will be given below of embodiments of the present invention using the drawings. In all the drawings, similar components are denoted by the same reference numerals and descriptions thereof will not be repeated as appropriate. In addition, the drawings are schematic diagrams and do not correspond to actual dimensional ratios.

A description will be given of an overview of the method for producing a substrate according to the present embodiment.

The method for producing a substrate according to the present embodiment includes a preparation step of preparing a substrate that has an uneven structure on a surface, an arrangement step of arranging the substrate in a chamber with a cleaning liquid held in at least recessed portions of the uneven structure, a supply step of supplying a sublimable substance in a liquid state or supplying a sublimable film formation composition in a liquid state that includes a sublimable substance to at least the recessed portions of the substrate arranged in the chamber, and a sublimation drying step of coagulating, sublimating, and thereby removing a film formed of the sublimable substance or the sublimable film formation composition that has been supplied, in which, when the dew point temperature of the atmosphere inside the chamber at 1 atm is T_{dp}°C and the minimum temperature of the surface of the film during a coagulation process is Tₘᵢₙ°C, the sublimation drying step is controlled such that T_{dp} and Tₘᵢₙ satisfy Tₘᵢₙ > T_{dp}.

According to the findings of the present inventors, it was found that, in a method for producing a substrate using a sublimation drying method, it is possible to stably suppress pattern collapse by controlling the dew point temperature (T_{dp}) at 1 atm in the atmosphere in a chamber, in which a film formed of a sublimable substance or a sublimable film formation composition is arranged, to be lower than the minimum temperature (Tₘᵢₙ) of the surface of the film during the coagulation process described above.

Although the detailed mechanism is not clear, by controlling the minimum temperature on the film surface to be higher than the dew point temperature in the chamber, it is possible to suppress water absorption and dew condensation on the film surface, thereby making it possible to suppress coagulation defects in a sublimable film and, as a result, it is presumed that it will be possible for the sublimable film to stably exhibit the ability to suppress pattern collapse.

In addition, when the water content (humidity) of the atmosphere in contact with a film formed of a sublimable substance or sublimable film formation composition is high, it is considered that water may be absorbed or condensed on the film surface, resulting in coagulation defects, however, it is difficult to observe the coagulation defects themselves.

On the other hand, using the surface temperature of the film and the dew point temperature of the atmosphere in contact with the film as indicators makes it possible to evaluate the tendency of the pattern collapse rate with good reproducibility.

The collapse rate, which is an indicator for evaluating the collapse status of an uneven pattern can be calculated, for example, when the shape is a convex columnar shape that makes it easy to determine collapse from an overhead image, by observing a test piece with a pattern formed thereon using a scanning electron microscope (SEM), counting the collapsed convex portions (pattern collapse) in the uneven structure, and calculating the ratio (collapse rate) with respect to the number of convex shapes within the observed range. It may be said that it is possible to stably suppress pattern collapse in a case where a test result, in which the collapse rate obtained by observation of a SEM image is 30% or less, is obtained with a probability of 50% or more. In addition, the test result in which the collapse rate is 30% or less may be preferably obtained with a probability of 70% or more and more preferably 80% or more.

In the present specification, each SEM image was measured at observation points separated by 1 mm or more from each other. In addition, the magnification of the SEM was adjusted such that 500 to 600 patterns were observed in each SEM image.

A detailed description will be given below of each step of the method for producing a substrate according to the present embodiment.

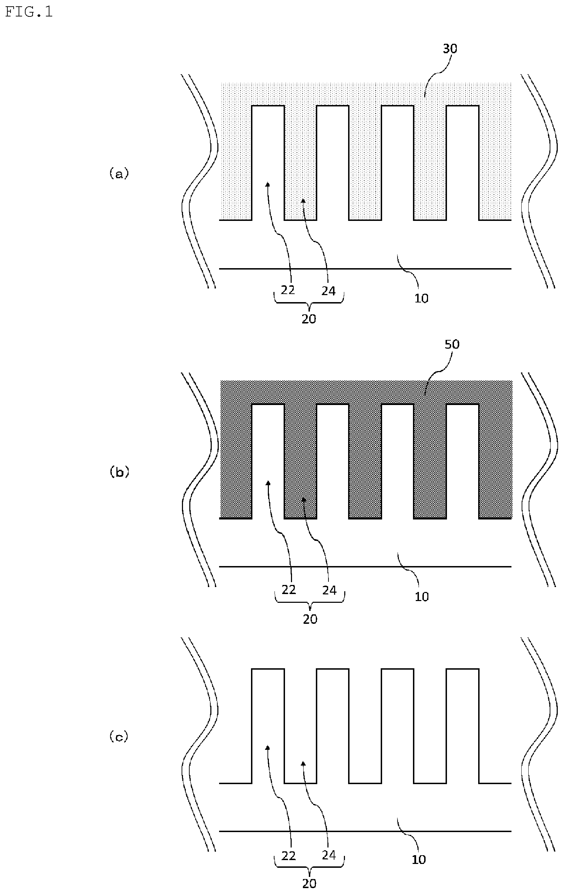

An example of the method for producing a substrate according to the present embodiment includes a preparation step, an arrangement step, a supply step, and a sublimation drying step. A description will be given of the method for producing a substrate using Fig. 1(a) to (c), taking the case of producing a semiconductor chip as an example.

As an overview of the process of producing a semiconductor chip, a fine uneven pattern is formed on the substrate (wafer) surface through film deposition, lithography, etching, and the like, then a wet treatment such as a cleaning step using water or organic solvents is performed to make the wafer surface clean, and a drying step is generally also performed to remove liquids such as cleaning liquids and rinsing liquids attached to the wafer by the wet treatment.

It is known that, during the drying step, semiconductor substrates having fine uneven patterns are prone to deformation and collapse of the uneven patterns.

In order to dry a substrate on which an uneven pattern is formed using a sublimable substance, generally, a step is performed in which a residual liquid such as a cleaning liquid remaining in the uneven pattern is replaced by a treatment liquid including the sublimable substance.

In the method for producing a substrate according to the present embodiment, first, a substrate 10 having an uneven structure 20 on the surface thereof is prepared (preparation step).

The following method, which is an example of a method for forming the uneven structure 20 on the surface of the substrate 10, may be used.

For example, after applying a resist to the wafer surface, the resist is exposed through a resist mask and the exposed resist or the unexposed resist is removed to produce a resist having a desired uneven pattern. In addition, it is possible to obtain a resist having an uneven pattern by pressing a mold having a pattern onto the resist. Next, the wafer is etched. At this time, the substrate surface corresponding to the recessed portions of the resist pattern is selectively etched. Finally, when the resist is peeled off, a wafer (substrate 10) having the uneven structure 20 on the surface is obtained.

The wafer on which the uneven structure 20 is formed and the material of the uneven structure 20 are not particularly limited and, as a wafer, it is possible to use various types of wafers such as silicon wafers, silicon carbide wafers, wafers formed of a plurality of components including silicon elements, sapphire wafers, various compound semiconductor wafers, and plastic wafers. In addition, for the material of the uneven structure 20, it is possible to use silicon-based materials such as silicon oxide, silicon nitride, polycrystalline silicon, and single-crystal silicon, metal-based materials such as titanium nitride, tungsten, ruthenium, tantalum nitride, and tin, materials combining the above, resist (photoresist) materials, and the like.

Fig. 1(a) is a cross-sectional view showing an example of the uneven structure 20. In the cross-sectional structure (in the substrate thickness direction) of the pattern of the uneven structure 20, at least one pattern dimension of the width and height, or, in the three-dimensional structure (three-dimensional coordinates of XYZ) of the pattern of the uneven structure 20, at least one pattern dimension of the width (length in the X-axis direction), height (length in the Y-axis direction), and depth (length in the Z-axis direction) may be, for example, 30 nm or less, 20 nm or less, or 10 nm or less. It is possible to reduce the pattern collapse rate by using the sublimation drying method of the present embodiment even in a case of using the substrate 10 having the fine uneven structure 20 like this.

In the cross-sectional view of Fig. 1, the slope of the uneven structure 20 is parallel to (does not intersect with) the substrate thickness direction; however, it is possible to suitably use the drying composition of the present embodiment even in cases where the slope of the uneven structure 20 is not parallel to the substrate thickness direction. The "not parallel" cases described above mean that suitable use is also possible, for example, in cases in which, in the cross-sectional structure of Fig. 1, the slope of the uneven structure 20 is perpendicular to the substrate thickness direction, cases in which the slope of the uneven structure 20 intersects (excluding perpendicularly) with the substrate thickness direction, or the like.

The lower limit of the aspect ratio of a convex portion 22 may be, for example, 3 or more, 5 or more, or 10 or more. It is possible to suppress pattern collapse even in the uneven structure 20 having the convex portion 22 with a fragile structure.

On the other hand, the upper limit of the aspect ratio of the convex portion 22 is not particularly limited, but may be 100 or less.

The aspect ratio of the convex portion 22 is expressed as the value obtained by dividing the height of the convex portion 22 by the width of the convex portion 22.

Next, the substrate 10 is set in a state of being arranged in a chamber with a cleaning liquid held in at least recessed portions 24 of the uneven structure 20 (arrangement step).

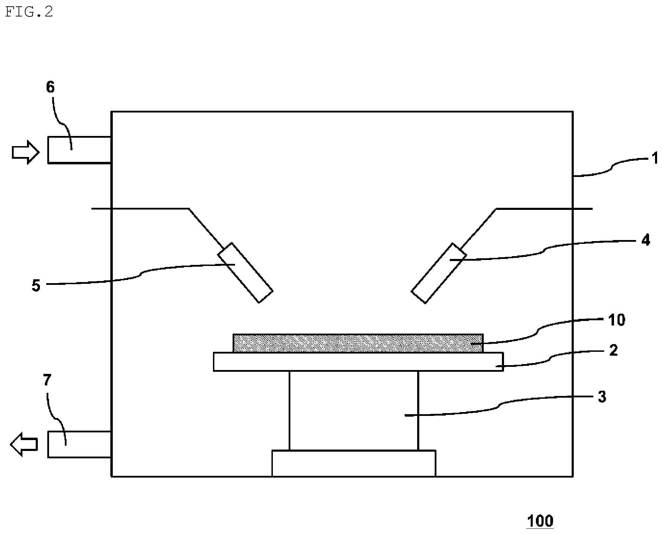

As an example of the arrangement step, a method is used in which the substrate 10 is arranged in a chamber 1 of a processing apparatus 100 in Fig. 2 and a cleaning liquid is supplied to the recessed portions 24 of the substrate 10 inside the chamber 1.

Fig. 2 is a cross-sectional view schematically showing the configuration of the processing apparatus 100 that processes the surface of the substrate 10.

The processing apparatus 100 in Fig. 2 is provided with the chamber 1, a rotation mechanism 3, a table 2, a nozzle 4, a nozzle 5, a gas inlet 6, and a gas outlet 7.

In the chamber 1, the substrate 10 is removably installed on the table 2. The table 2 is provided with a substrate holding mechanism such as a holding pin or a spin chuck (not shown). It is possible to rotate the table 2 around the thickness direction axis of the table 2 using the rotation mechanism 3.

For example, it is possible to supply a cleaning liquid from the nozzle 4 to the surface of the substrate 10 installed on the table 2 and to supply a sublimable substance in a liquid state or a sublimable film formation composition in a liquid state from the nozzle 5. The arrangement positions and orientations of the nozzle 4 and the nozzle 5 are not particularly limited as long as it is possible to efficiently supply the liquid to the surface of the substrate 10. In addition, since it is possible for the sublimable substance to be in a solid state, when the sublimable substance is cooled in a state of remaining at the nozzle tip or the like, the sublimable substance will coagulate and become a coagulated substance, and when the coagulated substance is unintentionally mixed into the surface of the substrate 10, there is a concern that this may influence the stability in suppressing pattern collapse. From this point of view, the temperature of the nozzle and the tip of the nozzle may be adjusted, or a shielding member or the like may be installed which is able to suppress residual sublimable substances in a liquid state, coagulated substances, and the like from mixing into the surface of the substrate 10.

It is possible to supply gas such as dry gas into the chamber 1 from the gas inlet 6 installed in the chamber 1 and it is possible to discharge residual gas and the supplied gas in the chamber 1 from the gas outlet 7. Each of the gas inlet 6 and the gas outlet 7 may be provided with a mechanism for varying the gas amount. In addition, the substrate 10 may have one or more gas supply ports that supply gas directly to the surface of the substrate 10. The gas supply port may eject gas so as to collide with the surface of the substrate 10, or may eject gas along the surface of the substrate 10. In addition, the gas inlet 6 may also serve as a gas supply port.

In addition, as necessary, a temperature adjustment device capable of raising or lowering the temperature of the atmosphere or the substrate 10 in the chamber 1 may be installed in the chamber 1, along with sensors such as a surface thermometer or a dew point thermometer.

As the cleaning liquid, water, an organic solvent, or the like is used and it is usually preferable to use at least one cleaning liquid selected from alcohols with 3 or fewer carbon atoms, such as methanol, 1-propanol, and 2-propanol. Due to this, it is possible to comparatively easily replace the cleaning liquid remaining on the uneven structure 20 of the substrate 10 with a sublimable substance in a liquid state or a sublimable film formation composition in a liquid state.

Subsequently, after the arrangement step, as shown in Fig. 1(a), a sublimable substance in a liquid state or a sublimable film formation composition in a liquid state 30 is supplied to at least the recessed portions 24 of the substrate 10 in the chamber 1 (supply step).

The sublimable substance and the sublimable film formation composition 30 during the supply step are preferably liquid in an environment of 20°C to 30°C and more preferably a solution. The supply may be carried out to fill part or all of the recessed portions 24 of the uneven structure 20 (may be described as "a step of supplying the sublimable film formation composition", or simply "filling step" or "supply step"). The supply may be carried out, for example, in an environment of 20°C to 30°C.

It is possible to implement the method for supplying the sublimable substance and the sublimable film formation composition 30 using any known method, but, for example, as shown in Fig. 2, a single-wafer method, represented by a spin method, in which, while holding and rotating wafers one by one almost horizontally, a composition is supplied near the center of rotation to replace a cleaning liquid or the like held in an uneven pattern on the substrate and fill the composition therein, a batch method in which a plurality of wafers are immersed in a tank of the composition and a cleaning liquid or the like held in the uneven pattern of the wafer is replaced and the composition is filled therein, or the like may be used.

The sublimable substance to be used may be purified in advance. For the purification of sublimable substances, a separation method using sublimation purification, filter purification, distillation, or the like is used.

Subsequently, after the supply step, as shown in Fig. 1(b), a film 50 formed from the supplied sublimable substance or sublimable film formation composition is coagulated in the chamber 1, and, as shown in Fig. 1(c), the sublimable film formed by coagulating the film 50 is removed by sublimation (sublimation drying step).

The film 50 formed of a sublimable substance or a sublimable film formation composition refers to both a coating film and a sublimable film. At this time, the film 50 has the same composition as the sublimable substance or the sublimable film formation composition 30 immediately after supply, however, the components from the sublimable substance or the sublimable film formation composition 30 may be volatilized such that the component ratio may become different from that of the original composition.

In the present specification, the term "sublimable film" refers to a sublimable substance formed in the form of a film on the substrate 10. This sublimable film does not have fluidity like a liquid and may have a not volatile solvent or the like in the film.

In addition, in order to form a sublimable film, the sublimable substance in a liquid state or the sublimable film formation composition in a liquid state 30 is supplied onto the substrate 10 and spread into a film shape. At this time, since the material of the sublimable film has fluidity, a film in a liquid state (liquid film) is formed on the substrate 10. In the present specification, the liquid film is referred to as a "coating film."

A sublimable substance or a sublimable substance in the sublimable film formation composition in a liquid state 30 is coagulated and the film 50 including a coagulated substance of the sublimable substance is formed on the uneven structure 20 (may be referred to below as "step of forming a sublimable film" or simply "coagulation step" for the purpose of explanation). Due to this, it is possible to suppress the pattern collapse of the uneven structure 20 using the film 50 filled inside the recessed portions 24 of the uneven structure 20.

The formed film 50 is preferably placed such that the surface of the film 50 covers at least the convex portion 22 of the uneven structure 20 in order to more stably suppress pattern collapse. In addition, the film 50 may be present in the recessed portions 24 to the extent that it is possible to suppress pattern collapse and may not necessarily completely fill the recessed portions 24.

As a method for causing coagulation, a solid sublimable substance may be precipitated by cooling, but, particularly in the case of the sublimable film formation composition 30, the solvent may be volatilized by heating or applying appropriate environmental conditions and the solid sublimable substance may be precipitated by the heat of vaporization.

In the present embodiment, the sublimable film formation composition 30 preferably includes a sublimable substance and a solvent. By appropriately selecting the type of solvent included in the sublimable film formation composition 30, it is also possible to volatilize (dry) the solvent, for example, at room temperature and normal pressure (20°C to 25°C, 1 atm).

In addition, the lower limit of the coagulation point of the sublimable substance is, for example, 5°C or higher, preferably 20°C or higher, and more preferably 50°C or higher under 1 atm. By setting the lower limit of the coagulation point of the sublimable substance to the lower limit value or higher described above, extreme cooling is not necessary, it is possible to coagulate the sublimable substance by the heat of vaporization of the solvent, and it is also not necessary to keep the dew point temperature in chamber 1 extremely low.

When coagulating the film 50 at room temperature and normal pressure, the volatilization of the solvent may be accelerated, as necessary, by, for example, a method for rotating the substrate 10, a method for blowing an inert gas onto the substrate 10, or the like.

In the coagulation process, when the dew point temperature at 1 atm of the atmosphere in the chamber 1 in which the film 50 is arranged is T_{dp}°C and the minimum temperature of the surface of the film 50 is Tₘᵢₙ°C, T_{dp} and Tₘᵢₙ are controlled to satisfy Tₘᵢₙ > T_{dp}. In addition, since coagulation is normally considered to occur from the surface of the film 50, Tₘᵢₙ > T_{dp} is preferably satisfied at least until the surface of the film 50 is coagulated, and Tₘᵢₙ > T_{dp} may be satisfied until the coagulation of the film 50 is completed and a sublimable film is obtained, which is more preferable.

The "coagulation process" may be a period during which the coagulation phenomenon of the film 50 is occurring (progressing). Alternatively, as will be described below, the "coagulation process" may refer to the period from the time when the surface temperature of the film 50 begins to decrease to the time when no increase in the surface temperature of the film 50 is observed.

In the present specification, the "atmosphere" of the atmosphere that is in contact with the film 50 (coating film and sublimable film) usually refers to the air, gas, or the like that comes into contact with the surface of the film 50 during the coagulation process, but when the surface of the film 50 is used as a reference, the "atmosphere" may refer to a fluid present up to a position separated from the reference by 10 mm to the outside of the film.

The dew point temperature T_{dp} is the dew point temperature of the atmosphere described above under 1 atm (atmospheric pressure) and is measurable using a dew point meter or the like. As long as the dew point meter is able to evaluate whether T_{dp} is an appropriate value, it is possible to use any known method and, specifically, possible examples thereof include a chilled mirror dew point meter or an electrostatic capacity type dew point meter. In addition, a method of measuring relative humidity or absolute humidity for conversion into the dew point temperature may be used. It is possible to use a known method to measure relative humidity or absolute humidity, and a specific example thereof is an electric hygrometer.

In addition, when supplying a fluid with a desired dew point temperature into the chamber 1 and bringing the fluid into contact with the surface of the film 50 (coating film and sublimable film), in a case where the change in dew point temperature of the fluid is negligibly small between the time of supply from the fluid supply port and the time of the contact described above, the dew point temperature of the fluid at the time of supply may be regarded as the dew point temperature T_{dp} of the atmosphere in the chamber 1.

A known gas drying method is used as a method for adjusting the dew point temperature to be low and specific examples thereof include a treatment of supplying dry gas to the interior of the chamber 1 or replacing a gas in the interior of the chamber 1 with dry gas in a step before the supply step, a treatment of bringing a dry gas into contact with the surface of the film 50 during the coagulation process, a treatment of heating the substrate 10 during the coagulation process, and the like. The coagulation process of the film in the sublimation drying step may include one or two or more treatments selected from the group consisting of these treatments. In such a method, the dry gas is preferably supplied not only to the region near the film 50 but also to the entire chamber in which the film 50 is installed, and more preferably fills the entire chamber. This makes it possible to stably maintain the environmental state near the film 50 during the coagulation process.

When adjustment to lower the dew point temperature is performed after the arrangement step and before the supply step, it is possible to suppress moisture from being absorbed by the supplied sublimable substance or sublimable film formation composition in a liquid state, which is preferable.

In addition, as long as the dew point temperature in the coagulation process satisfies Tₘᵢₙ > T_{dp}, the adjustment completion time is not limited, but may be until the coagulation is completed and the sublimable film is formed. Specifically, the sublimation drying step may include a treatment of supplying dry gas to the interior of the chamber 1 and discharging the gas from the interior of the chamber 1, at least during the coagulation process of the film 50.

In addition, even while removing the sublimable film, the dew point temperature may continue to be adjusted to a low value.

It is possible to supply the dry gas into the chamber 1 of the processing apparatus 100 in Fig. 2 through the gas inlet 6 and discharge the dry gas to the outside through the gas outlet 7.

For example, a treatment may be carried out in which the gas is blown toward the surface of the substrate 10 or the dry gas may be made to flow or blown to be parallel to the surface, or the inside of the chamber may be filled with dry gas. In addition, in a case where dry gas is supplied, evacuation may also be performed at the same time and new dry gas may be continuously supplied. In a case of using a sublimable film formation composition, since the volatilized solvent is released into the chamber 1, dry gas is supplied and the inside of the chamber 1 is evacuated at the same time and new dry gas is preferably constantly supplied into the chamber 1 at least until the coagulation of the film 50 is completed.

The dry gas may be any gas that does not interfere with sublimation drying, for example, dry air, dry inert gas, or the like, with dry inert gas being particularly preferable, without being limited thereto. Specific examples of the gas type of the dry inert gas include rare gases such as nitrogen gas and argon gas.

It is possible to measure the surface temperature of the film 50 from the coating film to the sublimable film using a noncontact radiation thermometer or the like. In the present specification, since a coagulated coating film is a sublimable film, there is no particular distinction between the temperature of the coating film and the temperature of the sublimable film.

In the film 50 formed of the sublimable film formation composition 30 including a sublimable substance and a solvent, first, cooling occurs due to volatilization of the solvent (heat of vaporization), and then a phenomenon occurs in which heat is transferred from the periphery such that the temperature approaches the environmental temperature. Therefore, the surface temperature of the film 50 decreases after the sublimable substance or the sublimable film formation composition 30 is supplied to the substrate 10, and in a case where the substrate 10 is not heated after reaching the minimum temperature Tₘᵢₙ, the temperature increases to approximately the temperature of the atmosphere inside the chamber 1 and the temperature increasing stops. The surface temperature of the film 50 when the temperature increasing stops in this manner is set as Tᵤₚ.

The rate at which the surface temperature decreases or increases is not particularly limited, but may proceed gradually and the rate does not need to be constant.

In the coagulation process, T_{dp} and Tₘᵢₙ are preferably controlled to satisfy, for example, Tₘᵢₙ-T_{dp} ≥ 10, preferably Tₘᵢₙ-T_{dp} ≥ 20, and more preferably Tₘᵢₙ-T_{dp} ≥ 30. Due to this, it is also possible to reduce variations in the ability to suppress collapse depending on the type of sublimable substance.

In the coagulation process, T_{dp} and Tᵤₚ may be controlled to satisfy, for example, Tᵤₚ > T_{dp}, and preferably controlled to satisfy Tᵤₚ-T_{dp} ≥ 20 and more preferably Tᵤₚ-T_{dp} ≥ 30. Due to this, it is possible to further increase the stability in suppressing pattern collapse during sublimation drying.

In addition to lowering the dew point temperature T_{dp} of the atmosphere in the chamber 1, the dew point temperature T_{dp} may be relatively lowered by increasing the temperature of the coating film and the sublimable film. As a method for increasing the surface temperature of the film 50, examples thereof include heating the sublimable substance and the sublimable film formation composition to be supplied onto the substrate 10 in advance before use in the coating film forming step, heating the substrate 10 to be dried in advance, heating the substrate 10 to be dried and/or the composition in the coating film and/or sublimable film forming step, and the like.

Subsequently, as shown in Fig. 1(c), the sublimable film formed by coagulating the film 50 is sublimated and removed. That is, the solid sublimable substance is sublimated to remove the film 50 on the uneven structure 20 (for the purpose of explanation, this step may be referred to below as a "step of removing a sublimable film" or simply a "removal step").

It is possible to appropriately select the method for sublimating the sublimable substance according to the boiling point of the sublimable substance. For example, in a case where the boiling point is comparatively low, the sublimable substance may be sublimated under normal temperature and normal pressure, but heating or depressurization may be used as necessary.

In the present embodiment, the coagulation step and the removal step are described separately for ease of explanation, but do not need to be clearly separated and the coagulation of the film, and the removal of the sublimable film may occur continuously or occur in such a short time that separation is difficult.

The production method shown in Fig. 1 has a wafer pattern as a target, but the present invention is not limited thereto. The method for producing a substrate according to the present embodiment is also able to suppress the collapse of the resist pattern by using the sublimable film formation composition of the present invention in the cleaning and drying steps thereof with the resist pattern as a target.

Although a description was given of a production method in which the supply step described above is carried out after a cleaning step, without being limited thereto, the supply step may be carried out after various treatments carried out on the uneven structure 20. For example, the supply step may be performed after a treatment with a chemical solution for forming a water-repellent protective film on the uneven structure 20.

In addition to the steps described above, the method for producing a substrate may also use one or two or more known treatments in combination. For example, after the removal step described above, a surface treatment such as a plasma treatment may be performed.

It is possible to apply the sublimation drying method of the present embodiment to various uses other than the method for producing a substrate described above.

The sublimation drying method includes a sublimation drying step in which a film formed of a sublimable substance or a sublimable film formation composition including a sublimable substance described below is coagulated and removed by sublimation, and, as described above, in the sublimation drying step, when the dew point temperature of the atmosphere in the vicinity of the film at 1 atm is T_{dp}°C and the minimum temperature of the surface temperature of the film during the coagulation process is Tₘᵢₙ°C, T_{dp} and Tₘᵢₙ are controlled to satisfy Tₘᵢₙ > T_{dp}.

A detailed description will be given below of the sublimable substance and sublimable film formation composition of the present embodiment.

### (Sublimable Film Formation Composition)

The sublimable film formation composition includes one or two or more sublimable substances.

The sublimable substance may be a substance in which the entire film disappears due to a predetermined heat treatment, or may be a substance that disappears when the film is left at 23°C under 1 atm. In the method for producing a substrate, the sublimable film is not a permanent film that remains permanently on the substrate, but is used as a sacrificial film to be removed in subsequent steps. Accordingly, it is possible to use the sublimable film formation composition as a composition for forming a sublimable sacrificial film.

The lower limit of the content of the sublimable substance is, for example, 0.1% by mass or more in the sublimable film formation composition, preferably 0.5% by mass or more, and more preferably 0.8% by mass or more. Due to this, in the sublimable film formation composition, there is a tendency for the sublimable substance to uniformly coagulate more easily.

On the other hand, the upper limit of the content of the sublimable substance is, for example, 80% by mass or less in the sublimable film formation composition, preferably 50% by mass or less, and more preferably 40% by mass or less. Due to this, the cooling effect due to the heat of vaporization of the solvent is obtained more easily and there is a tendency for the coagulation of the sublimable substance to accelerate more easily, which is preferable. In addition, it is easier to keep the time required for sublimation (sublimation time) short, which is preferable.

In addition, preferably, the sublimable film formation composition 30 does not contain water or contains water in an amount of 10% by mass or less with respect to 100% by mass of the sublimable substance. Due to this, it is possible to improve the ability of the sublimable film formation composition 30 to suppress pattern collapse.

In a case where the sublimable substance has a polar moiety, when the mass ratio is less than 10 per 100 parts of the sublimable substance, it is possible to stably suppress pattern collapse even when the sublimable film formation composition includes moisture. Examples of the above polar moieties include - OH, -O-, -(C=O)-, -NH₂, -(NH)-, tertiary amino groups, and the like.

In addition, in a case where the sublimable substance is non-polar, or a case where water is not a good solvent for the sublimable substance, it is desirable for the sublimable film formation composition to include as little moisture as possible. Although the specific mechanism is not clear, it is presumed that, when the sublimable substance is non-polar, the sublimable substance and water undergo phase separation such that it is no longer possible to stably suppress pattern collapse as a result. Although it is desirable for the sublimable film formation composition to include as little moisture as possible, the mass ratio of the moisture content may be less than 0.01 per 100 parts to the sublimable substance, for example.

The first sublimable film formation composition (described below as the "sublimable film formation composition of the first embodiment") may include a solvent A1 having an appropriate ability to dissolve a sublimable substance and an appropriate volatility, and the second sublimable film formation composition (described below as the "sublimable film formation composition of the second embodiment") may include a solvent A2 having an appropriate ability to dissolve a sublimable film and a solvent B2 having an appropriate volatility.

Although the detailed mechanism is not certain, it is considered that, by using highly volatile solvents (solvent A1, solvent B2) that are more volatile than the sublimable substance, the ability to form a film is improved, while by using highly soluble solvents (solvent A1, solvent A2) for which the ability to dissolve the sublimable substance is comparatively high, it is possible to suppress early excessive precipitation of the sublimable substances, thereby making it possible to suppress pattern collapse originating from sublimable substances that were precipitated early.

### (Sublimable Substance)

In the present specification, "sublimable substance" refers to a substance having a vapor pressure in a solid state.

In principle, it is possible to use the sublimable substance as long as the substance is solid and has a vapor pressure at a specific temperature.

As described above, the lower limit of the coagulation point of the sublimable substance is, for example, 5°C or higher under 1 atm, preferably 20°C or higher, and more preferably 50°C or higher. Due to this, in a case of being applied to the method for producing a substrate, it is unnecessary to treat the sublimable substance at an extremely low temperature for coagulation and the production stability of the semiconductor substrate is increased.

On the other hand, the upper limit of the coagulation point of the sublimable substance is, for example, 220°C or lower under 1 atm, preferably 200°C or lower, and more preferably 180°C or lower. Due to this, in a case of being applied to the method for producing a substrate, it is unnecessary to treat the sublimable substance at an extremely high temperature for sublimation and the production stability of the semiconductor substrate is increased.

The lower limit of the coagulation heat of the sublimable substance is not particularly limited, but may be, for example, 1 J/g or more, preferably 5 J/g or more, and more preferably 10 J/g or more.

On the other hand, the upper limit of the coagulation heat of the sublimable substance is, for example, 200 J/g or less, preferably 100 J/g or less, and more preferably 50 J/g or less. Due to this, it is possible to suppress the occurrence of striated collapse. In the present specification, striated collapse refers to a state in which a pattern collapses continuously in a predetermined direction. In addition, a case where collapse occurs around a region where there is no pattern collapse may be referred to as a striated collapse.

The sublimable substance may be formed such that not volatile substances becoming residues after sublimation are substantially not included. It is possible to remove not volatile substances from the sublimable substance by separation methods such as sublimation refining or distillation. Substantially not included means 1% by mass or less in 100% by mass of the sublimable substance, preferably 0.5% by mass or less, or that a case of unavoidable mixing in may be acceptable.

The lower limit of the boiling point of the sublimable substance is, for example, 60°C or higher under 1 atm, preferably 100°C or higher, and more preferably 110°C or higher. Due to this, it is possible to stably form sublimable films including sublimable substances.

On the other hand, the upper limit of the boiling point of the sublimable substance is, for example, 300°C or lower under 1 atm, preferably 280°C or lower, and more preferably 250°C or lower. Due to this, refining of the sublimable substance is easy. In addition, in a normal temperature and normal pressure process, the sublimation of the sublimable substance is easy and the production efficiency is increased.

As the boiling point or sublimation point of a sublimable substance including a plurality of substances, the boiling point or sublimation point of the component with the highest content ratio (% by mass) among the components included in the sublimable substance is adopted (however, in a case where there are two or more components with the highest content ratio, the boiling point or sublimation point which is the highest temperature is adopted).

For the boiling point of sublimable substances, the initial boiling point as defined in JIS K 2254:2018 (ISO 3405) is adopted.

In cases where the sublimation point is typically used for a substance, the sublimation point is used.

In addition, for the coagulation point of the sublimable substance, the coagulation start temperature determined using DSC under a condition of -10°C/min is adopted. As the coagulation point of a sublimable substance including a plurality of substances, the coagulation point of the component with the highest content ratio (% by mass) among the components included in the sublimable substance is adopted (however, in a case where there are two or more components with the highest content ratio, the coagulation point which is the higher temperature is adopted).

The temperature range at which the sublimable substance is solid and has a vapor pressure (also referred to below as "sublimation temperature range") may, for example, be 10°C or higher. Due to this, even when used in an environment of 20°C to 25°C, which is a typical room temperature in a clean room, it is possible to coagulate the sublimable substance by cooling due to the heat of vaporization of the solvent in the sublimable film formation composition.

In addition, when the sublimation temperature range is in a range of 20°C to 25°C, sublimation acceleration treatments such as heating and depressurization are not necessary and it is possible to sublimate the sublimable substances comparatively easily and to remove the sublimable film while adopting the current conditions for the substrate production process as they are.

The vapor pressure when defining the sublimation temperature range is, for example, 10 Pa or more and preferably 50 Pa or more.

In the present specification, "to" indicates that the upper limit value and lower limit value are included, unless otherwise expressly stated.

Sublimable substances are not limited as long as application is possible to substrate materials such as semiconductors, and examples thereof include non-halogenated sublimable substances S1 with a comparatively low coagulation heat, non-halogenated sublimable substances S2 with a comparatively high coagulation heat, sublimable substances S3 where the difference between the coagulation point and boiling point is comparatively small, halogen-containing sublimable substances S4 including halogen elements, and the like. The above may be used alone or in a combination of two or more.

The coagulation heat of the non-halogenated sublimable substance S1 is preferably 50 J/g or less and more preferably 40 J/g or less. For S1, the difference between the coagulation point and the boiling point tends to be comparatively large, thus, distillation and refining as a liquid are possible. The use of S1 makes it possible to suppress the occurrence of striated collapse.

The coagulation heat of the non-halogenated sublimable substance S2 is preferably over 50 J/g.

The difference between the coagulation point and the boiling point of the sublimable substance S3 is, for example, 50°C or less, preferably 40°C or less, and more preferably 30°C or less.

As the halogen-containing sublimable substance S4, a fluorine-containing sublimable substance including a fluorine element as a halogen element may be used.

Among the above, the sublimable substances S1 to S3 are preferably used from the viewpoint of pattern collapse suppression.

Examples of sublimable substances include norbornene, norbornane, camphor, pyrazine, 2,3-dichloropyrazine, 2,6-dichloropyrazine, 2,6-dichloropyridine, tetrahydrodicyclopentadiene, dimethyl oxalate, isoborneol, neopentyl alcohol, neopentyl glycol, ethylene carbonate, and the like. Among the above, neopentyl alcohol, camphor, pyrazine, tetrahydrodicyclopentadiene, dimethyl oxalate, isoborneol, and ethylene carbonate may be used. The above may be used alone or used in a combination of two or more. In addition, in a case where optical isomers are present, one or both may be used.

### (Solvent)

The sublimable film formation composition of the present embodiment preferably includes one or two or more solvents A in which the saturation solubility of the sublimable substance is more than 10% by mass. Solvent A is defined to encompass the solvent A1 and the solvent A2 described above.

By using the solvent A having the ability to dissolve the sublimable substance, when the sublimable film formation composition is supplied onto the substrate through a nozzle, it is possible to suppress the occurrence of coagulation of the sublimable substance at the tip of the nozzle.

The saturation solubility is determined from the saturation concentration (% by mass) of the sublimable substance dissolved in the solvent.

In a case where a plurality of types of solvent are included, a saturation solubility value individually specified for each solvent is adopted.

In a case where the sublimable film formation composition includes a plurality of sublimable substances, as the saturation solubility, the saturation concentration of the sublimable substance with the highest content ratio (% by mass) in the composition is adopted (however, in a case where two or more kinds of sublimable substance with the highest content are present, the largest saturation concentration value is adopted).

The lower limit of the saturation solubility of the sublimable substance with respect to the solvent A is, for example, more than 10% by mass, preferably 30% by mass or more, more preferably 40% by mass or more, even more preferably 50% by mass or more, and yet more preferably 60% by mass or more. Due to this, it is possible to reduce the pattern collapse ratio.

On the other hand, the upper limit of the saturation solubility of the sublimable substance with respect to the solvent A may be, for example, 99% by mass or less or 95% by mass or less.

In addition, the sublimable film formation composition may use the solvent A compatible with respect to the residual liquid remaining on the substrate surface. Due to this, in the supply step, it is possible for the residual liquid to be efficiently replaced by the sublimable film formation composition and for a residual liquid drying treatment to be stably performed.

As described above, examples of the residual liquid include common solvents used in the semiconductor cleaning step, specifically, water, alcohols with 3 or fewer carbon atoms (for example, methanol, 1-propanol, 2-propanol, and the like), mixtures thereof, and the like.

Having compatibility means that the dissolved amount of the solvent used in the cleaning step with respect to 1 part by mass of the solvent A at 25°C and 1 atm is, for example, 0.05 parts by mass or more.

The composition including one or two or more of the solvent A1 for which the saturation solubility of the sublimable substance is more than 10% by mass and the boiling point is lower by 5°C or more than the boiling point of the sublimable substance at 1 atm will be referred to as the sublimable film formation composition of the first embodiment.

In this embodiment, the solvent A1 is selected from solvents A that satisfy a condition (1) that the boiling point thereof is lower by 5°C or more than the boiling point of the sublimable substance at 1 atm.

In condition (1), the (boiling point of the sublimable substance at 1 atm - boiling point of the solvent A1) may be 5°C or more, preferably 50°C or more, and more preferably 80°C or more and may be 200°C or less and preferably 180°C or less.

In the present specification, in a case where a plurality of solvents are included, as the boiling point of each solvent, the azeotropic point is adopted in a case of an azeotropic solvent. In a case where the solvent is not an azeotropic solvent, the boiling point specified for each solvent is adopted individually.

In the sublimable film formation composition of the first embodiment, it is considered that, by including at least one such solvent A1, the highly soluble solvent A1 suppresses excessive early-stage precipitation of the sublimable substance and the solvent A1 which is more highly volatile than the sublimable substance is able to accelerate film formation (coagulation of the sublimable substance) of the sublimable film due to the heat of vaporization. Due to this, after forming and removing the sublimable film, it is also possible to reduce the pattern collapse rate and to suppress striated collapse.

In addition to the solvent A described above, it is possible for the sublimable film formation composition of the present embodiment to include one or two or more of the solvents B in which the boiling point is lower than the boiling point of the sublimable substance at 1 atm. The solvent B is defined to encompass the solvent B1 and the solvent B2 described above.

The sublimable film formation composition of the first embodiment may include one or two or more of the solvent A1 described above and one or two or more of the solvent B1 in which the boiling point is lower than the boiling point of the solvent A1.

As long as the solvent B1 is a solvent for which the boiling point is lower than that of the solvent A1 among the solvents B, the saturation solubility of the sublimable substance in the solvent B1 is not particularly limited and use is possible even when lower than the saturation solubility of the solvent A1. The difference between the boiling point of the solvent A1 and the boiling point of the solvent B1 is, for example, 5°C or more, preferably 10°C or more, and more preferably 15°C or more and may be 200°C or less or may be 150°C or less.

The boiling point of the solvent B1 is, for example, 15°C to 85°C, preferably 20°C to 80°C, and more preferably 25°C to 70°C.

The lower limit of the content of the solvent A1 is, for example, 0.5% by mass or more in the sublimable film formation composition, preferably 0.8% by mass or more, and more preferably 0.9% by mass or more.

In addition, in a case where the solvent A1 is the main component of the solvent in the sublimable film formation composition, the content of the solvent A1 in the sublimable film formation composition may be 50% by mass or more, more preferably 80% by mass or more, and even more preferably 90% by mass or more. At this time, in a case where other solvents are used, the solvent B1 is preferably used as the solvent. In such a case, the content of the solvent A1 in the sublimable film formation composition may be a value greater than the solvent B1.

On the other hand, in a case where the solvent of the sublimable film formation composition includes substantially only the solvent A1 and/or a case where the solvent A1 is the main component of the solvent of the sublimable film formation composition, the upper limit of the content of the solvent A1 may be, for example, 99.9% by mass or less, preferably 99.5% by mass or less, and more preferably 99.2% by mass or less. In addition, in a case where the sublimable film formation composition includes the solvent A1 and the solvent B1 and the main component of the solvent is not A1, the content of the solvent A1 in the sublimable film formation composition may be, for example, less than 50% by mass, preferably 30% by mass or less, and more preferably 15% by mass or less.

The composition including one or two or more of the solvents A2, in which the saturation solubility of the sublimable substance is more than 10% by mass, and one or two or more of the solvent B2, in which the content in the sublimable film formation composition is greater than the content of the solvent A2 and the boiling point is lower than the boiling point of the sublimable substance at 1 atm and is lower than the boiling point of the solvent A2 will be referred to as the sublimable film formation composition of the second embodiment.

In this embodiment, the solvent A2 is selected from the solvents A described above. (The boiling point of the sublimable substance at 1 atm - boiling point of the solvent A2) may be 0°C, may be 0°C or more and less than 5°C, or may be 5°C or more and 200°C or less. In addition, from the viewpoint of easy coagulation of the sublimable substance, for example, it may be that 0°C or more and 200°C or less is preferable and 5°C or more and 200°C or less is more preferable.

The solvent B2 is a solvent capable of accelerating the film formation of the sublimable film by volatilizing before the solvent A2, and, as long as the boiling point is lower than the boiling point of the solvent A2 and the boiling point of the sublimable substance, the saturation solubility of the sublimable substance is not particularly limited and use is possible even when lower than the saturation solubility of the sublimable substance in solvent A2.

However, in the present embodiment, the content of the solvent B2 in the sublimable film formation composition is greater than the content of the solvent A2. Preferably, the solvent B2 may be included as the main component in the sublimable film formation composition. The main component means that the lower limit of the content of the solvent B2 in the sublimable film formation composition is, for example, 50% by mass or more, preferably 70% by mass or more, and more preferably 90% by mass or more. The upper limit of the content of the solvent B2 may be, for example, 99.8% by mass or less, 99.5% by mass or less, or 99% by mass or less.

In the sublimable film formation composition including the solvent B2 as a main component, the content of the solvent A2 is, for example, 0.1% by mass to 30% by mass and preferably 0.5% by mass to 10% by mass.

In the sublimable film formation composition of the second embodiment, by including at least one of each of the solvent A2 and the solvent B2, the formation of the sublimable film (the coagulation of the sublimable substance) is accelerated by the relative volatilization and the heat of vaporization of the solvent B2. At this time, it is considered that, the sublimable substance and the solvent A2 remain, but, in this residue, the solvent A2 is able to dissolve the sublimable substance, thus, it is possible to suppress excessive early-stage precipitation of the sublimable substance. Due to this, after the sublimable film has been formed and removed, it is also possible to reduce the pattern collapse rate as well as to suppress striated collapse.

Including the solvent B2 as a main component in the sublimable film formation composition of the second embodiment makes it possible to reduce the film forming time of the sublimable film and also to keep the production costs of the substrate described above low.

In addition, the difference between the boiling point of the solvent A2 and the boiling point of the solvent B2 is not particularly limited, as long as the solvent A2 is able to remain after the solvent B2 has volatilized, and may be for example, 5°C or more, preferably 10°C or more, more preferably 15°C or more, and even more preferably more than 20°C and may be 200°C or less or 150°C or less.

The upper limit of the boiling point of the solvent B2 is, for example, 85°C or lower, preferably 80°C or lower, and more preferably 70°C or lower.

On the other hand, the lower limit of the boiling point of the solvent B2 may be, for example, 15°C or higher, preferably 20°C or higher, and more preferably 25°C or higher.

In a case where two or more of the solvents A1 are included in the first embodiment, as an example, the second and subsequent solvents A1 may be selected from solvents for which a saturation solubility of the sublimable substance with respect to the solvent A1 is 40% by mass or more and which have a boiling point of 200°C or lower and are preferably selected from solvents for which a saturation solubility of the sublimable substance is 75% by mass or more and which have a boiling point of 180°C or lower.

In a case where two or more of the solvent A2 and/or the solvent B2 are included in the second embodiment, as an example, the second and subsequent solvents A2 may be selected from solvents for which a saturation solubility of the sublimable substance with respect to the solvent A2 is 40% by mass or more and which have a boiling point which is the boiling point of the sublimable substance or lower, preferably selected from solvents for which a saturation solubility of the sublimable substance is 50% by mass or more and which have a boiling point of 210°C or lower, more preferably selected from solvents for which a saturation solubility of the sublimable substance is 60% by mass or more and which have a boiling point of 200°C or lower, and even more preferably selected from solvents for which a saturation solubility of the sublimable substance is 75% by mass or more and which have a boiling point of 180°C or lower.

In addition, in a case where two or more of the solvents A2 and one or more of the solvents B2 are included, the smaller the boiling point difference between the solvents A2, the more likely the solvents A2 are to remain when the solvent B2 is volatilized, which is preferable. The boiling point difference described above is not particularly limited as long as it is possible to exhibit the effects as the solvent A2, but, for example, it may be that the difference between the highest boiling point and lowest boiling point of the two or more solvents A2 is preferably 20°C or less, more preferably 15°C or less, and even more preferably 10°C or less. That is, the second and subsequent solvents A2 may have a difference in boiling point from the first solvent A1 of 10°C or less, 15°C or less, or 20°C or less, for example. In addition, at this time, the boiling point of the solvent B2 is lower than the lowest boiling point of the solvent A2.

In addition, the second and subsequent solvents B2 may be selected from solvents having a boiling point of, for example, 83°C or lower, preferably 80°C or lower, and more preferably 70°C or lower.

Examples of solvents used in the sublimable film formation composition include hydrocarbons, ethers, alcohols, ketones, esters, sulfoxides, nitrogen-containing compounds, and the like. Each of these solvent types may have one or more halogen atoms such as fluorine atoms and chlorine atoms in the molecule. The above may be used alone or in a combination of two or more.

As hydrocarbons, for example, it is possible to use alkanes or cycloalkanes with 4 to 10 carbon atoms, alkenes or cycloalkenes with 4 to 10 carbon atoms, aromatic hydrocarbons with 6 to 10 carbon atoms, and the like.

Specific examples of hydrocarbons include pentane, 3-methylpentane, hexane, heptane, octane, nonane, decane, isododecane, cyclopentane, cyclohexane, methylcyclohexane, 1,1-dichloroethane, 1,2-dichloroethane, 1,2-dichloroethylene, cis-1-chloro-3,3,3-trifluoropropene (1233Z), trans-1-chloro-3,3,3-trifluoropropene (1233E), toluene, benzene, xylene, and the like.

As ethers, for example, it is possible to use chained or cyclic ether compounds with 3 to 10 carbon atoms.

Specific examples of ethers include tetrahydrofuran, diethyl ether, dipropyl ether, diisopropyl ether, dibutyl ether, tert-butyl methyl ether, dioxane, 1,1,1,2,2,3,3,4,4-nonafluorobutyl methyl ether (Novec 7100), ethylene glycol monomethyl ether, ethylene glycol dimethyl ether, diethylene glycol dimethyl ether, propylene glycol monomethyl ether, propylene glycol dimethyl ether, and the like.

As alcohols, for example, it is possible to use primary, secondary, and tertiary alcohols with 1 to 10 carbon atoms, and the like.

Specific examples of alcohols include methanol, ethanol, 1-propanol, 2-propanol (IPA), 1-butanol, 2-butanol, cyclopentanol, cyclohexanol, 2-methyl-2-butanol, 4-methyl-2-pentanol, ethylene glycol, propylene glycol, 2,2,2-trifluoroethanol, 1,1,1,3,3,3-hexafluoro-2-propanol, 1,3-propanediol, and the like.

As ketones, for example, it is possible to use ketone compounds with 3 to 6 carbon atoms.

Specific examples of ketones include acetone, acetylacetone, methyl ethyl ketone, methyl propyl ketone, methyl butyl ketone, and the like.

Examples of esters include chained or cyclic ester compounds with 3 to 6 carbon atoms and the like.

Specific examples of esters include methyl acetate, ethyl acetate, n-propyl acetate, isopropyl acetate, butyl acetate, methyl lactate, ethyl lactate, ethyl acetoacetate, ethyl trifluoroacetate, γ-butyrolactone, ethylene glycol acetate, propylene glycol acetate, ethylene glycol monomethyl ether acetate, propylene glycol monomethyl ether acetate, and the like.

Examples of sulfoxides include dimethyl sulfoxide and the like.

Examples of nitrogen-containing compounds include formamide, N,N-dimethylformamide, N,N-dimethylacetamide, N-methyl-2-pyrrolidone, pyridine, and the like.

As the solvent A1, the solvent A2, the solvent B1, and the solvent B2, respectively, it is possible to select one or two or more of the solvents described above according to the sublimable substance included in the sublimable film formation composition.

From the viewpoint of achieving both high solubility in the sublimable substance and compatibility with, for example, water, an alcohol with 3 or fewer carbon atoms, or the like, which are often used as the residual liquid remaining on the substrate surface, as the solvent A1 and the solvent A2, it is particularly preferable to include at least one selected from the group consisting of ethers, alcohols, ketones, esters, and hydrocarbons having one or more halogen atoms such as fluorine atoms and chlorine atoms in the molecule. Possible specific examples thereof include tetrahydrofuran, methanol, ethanol, 1-propanol, 2-propanol, 1-butanol, 2-butanol, 2-methyl-2-butanol, acetone, methyl acetate, ethyl acetate, 1,1-dichloroethane, 1,2-dichloroethane, 1,2-dichloroethylene, cis-1-chloro-3,3,3-trifluoropropene, trans-1-chloro-3,3,3-trifluoropropene, and the like. In addition, among the above, more preferable examples thereof include methanol, ethanol, 1-propanol, 2-propanol, 2-butanol, 2-methyl-2-butanol, acetone, methyl acetate, cis-1-chloro-3,3,3-trifluoropropene, trans-1-chloro-3,3,3-trifluoropropene, and the like.

From the viewpoint of achieving both high volatility and compatibility with water, an alcohol with 3 or fewer carbon atoms, or the like, which are often used as the residual liquid remaining on the substrate surface, as the solvents B1 and B2, it is preferable to include at least one selected from the group consisting of hydrocarbons, ethers, alcohols, ketones, and esters. Possible specific examples thereof include pentane, 3-methylpentane, hexane, heptane, cyclopentane, cyclohexane, methylcyclohexane, 1,1-dichloroethane, 1,2-dichloroethane, 1,2-dichloroethylene, cis-1-chloro-3,3,3-trifluoropropene, trans-1-chloro-3,3,3-trifluoropropene, toluene, benzene, xylene, diethyl ether, dipropyl ether, diisopropyl ether, tetrahydrofuran, methanol, ethanol, 1-propanol, 2-propanol, 1-butanol, 2-butanol, acetone, methyl acetate, ethyl acetate, and the like. Among the above, more preferable examples thereof include pentane, hexane, cyclopentane, cyclohexane, methylcyclohexane, cis-1-chloro-3,3,3-trifluoropropene, trans-1-chloro-3,3,3-trifluoropropene, diethyl ether, tetrahydrofuran, methanol, ethanol, 1-propanol, 2-propanol, acetone, methyl acetate, and the like.

### (Other Solvents)

In addition to the solvent A1, the solvent A2, the solvent B1, and the solvent B2, the sublimable film formation composition may also include a solvent C for a purpose such as adjusting the wettability to the substrate and/or the uneven pattern, in a range in which the effect of the present invention is not impaired, or the sublimable film formation composition may be formed to substantially not include the solvent C.

Examples of solvent C include water, hydrocarbons, esters, ethers, ketones, sulfoxide solvents, alcohols, derivatives of polyhydric alcohols, nitrogen-containing compounds, and the like, and solvents which do not fall under the solvents described above.

Examples of the hydrocarbons described above are toluene, benzene, xylene, pentane, 3-methylpentane, hexane, heptane, octane, nonane, decane, cyclopentane, cyclohexane, methylcyclohexane, 1,1-dichloroethane, 1,2-dichloroethane, 1,2-dichloroethylene, cis-1-chloro-3,3,3-trifluoropropene (1233Z), trans-1-chloro-3,3,3-trifluoropropene (1233E), and the like, examples of the esters described above are ethyl acetate, butyl acetate, methyl acetate, n-propyl acetate, isopropyl acetate, butyl acetate, methyl lactate, ethyl lactate, ethyl acetoacetate, ethyl trifluoroacetate, γ-butyrolactone, and the like, examples of the ethers described above are diethyl ether, dipropyl ether, diisopropyl ether, dibutyl ether, tert-butyl methyl ether, tetrahydrofuran, dioxane, 1,1,1,2,2,3,3,4,4-nonafluorobutylmethyl ether (Novec 7100), and the like, examples of the ketones described above are acetone, acetylacetone, methyl ethyl ketone, methyl propyl ketone, methyl butyl ketone, and the like, examples of the sulfoxide solvent described above are dimethyl sulfoxide and the like, examples of alcohols are methanol, ethanol, 1-propanol, 2-propanol, butanol, 4-methyl-2-pentanol, 2-methyl-2-butanol, 4-methyl-2-pentanol, ethylene glycol, propylene glycol, 2,2,2-trifluoroethanol, 1,1,1,3,3,3-hexafluoro-2-propanol, 1,3-propanediol, and the like, examples of the derivatives of polyhydric alcohol described above are diethylene glycol monoethyl ether, ethylene glycol monomethyl ether, ethylene glycol monobutyl ether, propylene glycol monomethyl ether, propylene glycol monoethyl ether, diethylene glycol monoethyl ether acetate, ethylene glycol monomethyl ether acetate, ethylene glycol monobutyl ether acetate, propylene glycol monomethyl ether acetate, propylene glycol monoethyl ether acetate, and the like, examples of the nitrogen-containing compound described above are formamide, N,N-dimethylformamide, N,N-dimethylacetamide, N-methyl-2-pyrrolidone, pyridine, and the like, and among the above, solvents not corresponding to the solvents A1, A2, B1, and B2 are examples.

The suitable lower limit of the total content of solvents in the sublimable film formation composition is, for example, 20% by mass or more, preferably 50% by mass or more, and even more preferably 60% by mass or more. Due to this, the cooling effect due to the heat of vaporization of the solvent is obtained more easily and there is a tendency for the coagulation of the sublimable substance to proceed more easily, which is preferable.

On the other hand, the suitable upper limit of the total content of solvent in the sublimable film formation composition is, for example, 99.9% by mass or less, preferably 99.5% by mass or less and even more preferably 99.2% by mass or less. Due to this, there is a tendency for the sublimable substance to uniformly coagulate more easily on the substrate, which is preferable.

The sublimable film formation composition is in a liquid state, preferably a solution, at least when supplied to the substrate surface. From the viewpoint of easy supply in a stable manner, the sublimable film formation composition being liquid (preferably a solution) at -15°C to 50°C is preferable and being liquid (preferably a solution) at 0°C to 50°C is more preferable. Furthermore, from the viewpoint of simplification of the equipment configuration, the sublimable film formation composition being liquid (preferably a solution) at 20°C to 50°C such that no heat retention or heating is necessary for the liquid transfer mechanism for carrying out the supply to the storage container and the nozzles 4 and 5 is particularly preferable. In addition, from the viewpoint of easy handling (production, storage, transport, and the like), the sublimable film formation composition may be liquid (preferably a solution) at -15°C to 50°C and is more preferably liquid (preferably a solution) at 0°C to 40°C. Furthermore, from the viewpoint of simplification of the equipment configuration, being liquid (preferably a solution) at 20°C to 30°C such that no heat retention or heating is necessary for the liquid transfer mechanism or storage container is particularly preferable.

A description was given above of the embodiments of the present invention, but these are examples of the present invention and it is possible to adopt various configurations other than those described above. In addition, the present invention is not limited to the embodiments described above and variations, improvements, and the like in a range in which it is possible to achieve the purpose of the present invention are included in the present invention.

In addition, in the present specification, ordinal numerals such as "first", "second", and "third" and symbols such as "A" and "B", unless otherwise stated, are added merely to distinguish similarly named configurations and do not signify a specific feature (for example, order or importance) of the configuration. Examples

A detailed description will be given below of the present invention with reference to Examples, but the present invention is not limited in any way to the description of these Examples.

### <Production of Substrate>

First, a silicon substrate in which an uneven structure having a plurality of approximately columnar convex portions with an aspect ratio of 22 in a cross-sectional view and a pattern width of 19 nm with a pitch of 90 nm (total distance of the width of the convex portion and the interval of the adjacent convex portions) was formed on a surface was cut out to dimensions of 1 cm × 1.5 cm to prepare a substrate for evaluation (preparation step).

Subsequently, the surface of the uneven structure of the substrate for evaluation was then dry-cleaned by UV/O₃ irradiation.

Subsequently, the spin bowl of the spin coater was covered with a polyethylene glove bag having a gas inlet and outlet. The glove bag is formed such that it is possible to control the atmosphere in the interior of the glove bag.

Subsequently, the substrate for evaluation was placed in the spin coater in the glove bag and 2-propanol was supplied thereto such that the liquid (2-propanol) was in a state of being held in the recessed portions in the uneven structure (arrangement step).

By using the glove bag described above, it is possible to conduct a simulated experiment that imitates an experiment using a chamber of an actual semiconductor manufacturing device. The pressure inside the glove bag was made equal to atmospheric pressure (approximately 1 atm).

Subsequently, the atmosphere inside the glove bag was adjusted to the conditions of any one of the following atmospheres A, B, and C. For the dew point temperatures of atmospheres A, B, and C, the relative humidity of the gas supplied into the glove bag was measured and converted into the dew point temperature. Specifically, using the temperature-water saturated vapor pressure correspondence table shown in JIS Z 8806:2001, first, the relative humidity of the gas supplied into the glove bag was converted into water vapor pressure, then the temperature at which the water vapor pressure reached the saturated vapor pressure was set as the dew point temperature of the gas supplied into the glove bag.

### (Atmosphere A: Nitrogen Gas Atmosphere, Dew Point Temperature - 20°C)

Nitrogen gas (dew point temperature -20°C) supplied from a pressure swing adsorption type nitrogen gas supply device was supplied to the interior of the glove bag from the gas inlet under conditions of a flow rate of 20 L/min for approximately 30 to 60 minutes. By supplying nitrogen gas and evacuating the gas from the gas outlet of the glove bag, the dew point temperature inside the glove bag was made equal to that of the supplied nitrogen gas.

### (Atmosphere B: Mixed atmosphere of Nitrogen Gas and Air, Dew Point Temperature 6°C)

After supplying indoor air (temperature 25°C, relative humidity 60%: equivalent to a dew point temperature of 17°C) into the glove bag once, evacuation was carried out while supplying the same nitrogen gas as atmosphere A above, the supply and evacuation of nitrogen gas was stopped at a time point where the relative humidity became 30% (equivalent to a dew point temperature of 6°C), the gas inlet and outlet of the glove bag were closed, and the glove bag was left for approximately 10 minutes.

### (Atmosphere C: Air, Dew Point Temperature 17°C)

Indoor air (temperature 25°C, relative humidity 60%: equivalent to a dew point temperature of 17°C) was supplied into the glove bag.

Next, the substrate for evaluation was rotated at a rotation speed of 100 revolutions per minute using the spin coater and, after 5 to 10 seconds of rotation, the sublimable film formation composition described below was dropped at 23°C in a solution state onto the surface of the uneven structure while maintaining the rotation speed and the residual liquid of 2-propanol described above was replaced with the sublimable film formation composition (supply step).

In the supply step described above, any one of the sublimable film formation compositions 1 to 4 below was used as the sublimable film formation composition.
- Sublimable film formation composition 1: A composition obtained by mixing neopentyl alcohol and 1233Z at a mass ratio of 10:90. Moisture content 0.5% by mass with respect to 100% by mass of the sublimable substance.
- Sublimable film formation composition 2: A composition obtained by mixing camphor and IPA at a mass ratio of 1:99. Moisture content 0.8% by mass with respect to 100% by mass of the sublimable substance.
- Sublimable film formation composition 3: A composition obtained by mixing HFCPA and Novec 7100 at a mass ratio of 80:20. Moisture content 0.3% by mass with respect to 100% by mass of the sublimable substance.
- Sublimable film formation composition 4: A composition obtained by mixing HDCP and heptane at a mass ratio of 12:88. Moisture content 0.2% by mass with respect to 100% by mass of the sublimable substance.

### (Sublimable Substance)

- Neopentyl alcohol: boiling point 114°C, heat of coagulation 22 J/g
- Camphor: boiling point 204°C, heat of coagulation 38J/g
- HFCPA (1,1,2,2,3,3,4-heptafluorocyclopentane): boiling point 83°C, heat of coagulation 17J/g
- HDCP (endo-tetrahydrodicyclopentadiene): boiling point 195°C, heat of coagulation 13J/g

### (Solvent)

- 1233Z (cis-1-chloro-3,3,3-trifluoropropene): boiling point 39°C, neopentyl alcohol saturation solubility 78% by mass
- IPA: boiling point 82°C, camphor saturation solubility 62% by mass
- Novec 7100: boiling point 61°C, HFCPA saturation solubility 98% by mass or more
- Heptane: boiling point 98°C, HDCP saturation solubility 86% by mass

Saturation solubility signifies the saturation concentration of the sublimable substance dissolved in the solvent and was measured as follows.

First, a mixture was prepared by mixing a sublimable substance and solvent at a mass ratio of approximately 3:1, heating to 40°C once, and cooling to room temperature (approximately 25°C). In a case where a solid and a liquid coexisted in the mixture at room temperature, 10 µL of the liquid part was collected with a micro syringe, diluted 100 times (volume ratio) with a dilution solvent, and then analyzed by gas chromatography and converted to a mass ratio to determine the saturation solubility (% by mass). In a case where no precipitation of the sublimable substance occurred at room temperature and the solution was uniform, the same operation was performed by increasing the amount of sublimable substance with respect to the solvent. In addition, in a case where the liquid portion was small at room temperature and difficult to collect with a micro syringe, the same operation was performed by increasing the amount of solvent with respect to the sublimable substance. The calculation of the mass ratio based on gas chromatography was performed using a Shimadzu Corporation model GC-2010 gas chromatograph with a capillary column (model TC-1, manufactured by G.L. Sciences Inc., length 30 m, liquid phase thickness 5 µm, inner diameter 0.32 mm) attached thereto and an area ratio detected by an FID detector was converted to a mass ratio based on an area ratio of a diluent solution dissolving the sublimable substance and solvent at 1% by mass each. It is necessary for the dilution solvent used in the gas chromatography to be selected from solvents for which a sufficiently separated peak is obtained by gas chromatography from the sublimable substance and the solvent which is the measurement target, specifically, a solvent that is 0.1 minutes or more apart in the development time on the chromatogram was selected.

Subsequently, the rotation speed of the spin coater in the supply step was maintained, and after the sublimable film formation composition was spread on the substrate, the formation of a coating film was visually confirmed. The rotation was further continued, and the formation of a sublimable film (a coagulated film of a sublimable substance) was visually confirmed.

At this time, the temperature of the surface of the coating film and sublimable film was measured under atmospheric pressure (approximately 1 atm) using a non-contact radiation thermometer (Mother Tool Co., Ltd., MT-11). As a result, in a case where the surface temperature of the substrate immediately before application was approximately 22°C, the surface temperature of the film formed of the sublimable film formation composition 1 began to decrease from the start of volatilization of the solvent and, after decreasing to a minimum of approximately 12°C (the minimum temperature Tₘᵢₙ), gradually rose as the sublimable substance coagulated such that the final surface temperature of the sublimable film reached approximately 20°C (final temperature Tᵤₚ).

Subsequently, the rotation was continued until the disappearance of the sublimable film was visually confirmed (sublimation drying step).

### <Evaluation of Pattern Collapse Rate>

Thereafter, the obtained substrate was observed using a scanning electron microscope (SEM) (SU8010, manufactured by Hitachi High-Tech Corporation) and the ratio (pattern collapse rate) of convex portion collapse (pattern collapse) in the uneven structure was evaluated.

The "pattern collapse rate" was calculated by taking an electron microscope image (secondary electron image) using an SEM at a magnification with 500 to 600 convex portions in the field of view, counting the number of convex portions in the obtained image where a collapse occurred, and calculating the ratio of the convex portions in the field of view as a percentage. In addition, multiple electron microscope images were taken while changing the shooting location of the substrate for evaluation and the pattern collapse rate was calculated for each image. The numerical values were rounded according to JIS Z 8401 with a rounding width of 10 by rounding off.

The obtained results are shown in Table 1. The table lists the number of images corresponding to a pattern collapse rate of 0 to 30%, the number of images corresponding to 40 to 60%, and the number of images corresponding to 70 to 100%, respectively.

In addition, as an evaluation of reproducibility, the probability of the pattern collapse rate being 0 to 30% when the production of the substrate was repeated was calculated.

**[Table 1]**

| Method for Producing Substrate | | Unit | Example 1 | Example 2 | Example 3 | Example 4 | Example 5 |
|---|---|---|---|---|---|---|---|
| Sublimation drying step (during coagulation) | Atmosphere | | A | B | A | A | A |
| | Dew point temperature T_{dp} | °C | -20 | 6 | -20 | -20 | -20 |
| | Sublimable film formation composition | | 1 | 1 | 2 | 3 | 4 |
| | Minimum temperature Tₘᵢₙ | °C | 12 | 12 | 13 | 15 | 13 |
| | Final temperature Tᵤₚ | °C | 20 | 20 | 20 | 20 | 20 |
| Pattern collapse rate | 0% to 30% | Number of Images | 9 | 9 | 9 | 6 | 6 |
| | 40% to 60% | | 0 | 0 | 0 | 0 | 0 |
| | 70% to 100% | | 0 | 0 | 0 | 0 | 0 |
| | Reproducibility | % | 100 | 100 | 100 | 100 | 100 |

**[Continued Table 1]**

| Method for Producing Substrate | | Unit | Comparative Example 1 | Comparative Example 2 | Comparative Example 3 | Comparative Example 4 |
|---|---|---|---|---|---|---|
| Sublimation drying step (during coagulation) | Atmosphere | | C | C | C | C |
| | Dew point temperature T_{dp} | °C | 17 | 17 | 17 | 17 |
| | Sublimable film formation composition | | 1 | 2 | 3 | 4 |
| | Minimum temperature Tₘᵢₙ | °C | 12 | 13 | 15 | 13 |
| | Final temperature Tᵤₚ | °C | 20 | 20 | 20 | 20 |
| Pattern collapse rate | 0% to 30% | Number of Images | 4 | 0 | 0 | 0 |
| | 40% to 60% | | 1 | 0 | 3 | 2 |
| | 70% to 100% | | 4 | 9 | 6 | 7 |
| | Reproducibility | % | 44 | 0 | 0 | 0 |

The method for producing a substrate in Examples 1 to 5 obtained test results in which the pattern collapse rate obtained by observing SEM images is 30% or less with a probability of 50% or more and exhibited results in which it was possible to stably suppress pattern collapse in comparison with Comparative Examples 1 to 4.

This application claims priority based on Japanese Patent Application No. 2021-150186, filed on September 15, 2021, the entire disclosure of which is hereby incorporated herein.

### REFERENCE SIGNS LIST

- 1: Chamber
- 2: Table
- 3: Rotation mechanism
- 4, 5: nozzle
- 6: Gas inlet
- 7: Gas outlet
- 10: Substrate
- 20: Uneven structure
- 22: Convex portion
- 24: Recessed portion
- 30: Sublimable film formation composition
- 50: Film
- 100: Processing apparatus

## Claims

1. A method for producing a substrate, the method comprising:
a preparation step of preparing a substrate that has an uneven structure on a surface;
an arrangement step of arranging the substrate in a chamber with a cleaning liquid held in at least recessed portions of the uneven structure;
a supply step of supplying a sublimable substance in a liquid state or supplying a sublimable film formation composition in a liquid state that includes a sublimable substance to at least the recessed portions of the substrate arranged in the chamber; and
a sublimation drying step of coagulating, sublimating, and thereby removing a film formed of the sublimable substance or the sublimable film formation composition that has been supplied,
wherein, when a dew point temperature of an atmosphere inside the chamber at 1 atm is T_{dp}°C and a minimum temperature of a surface of the film during a coagulation process is Tₘᵢₙ°C, the sublimation drying step is controlled such that T_{dp} and Tₘᵢₙ satisfy Tₘᵢₙ > T_{dp} .

2. The method for producing a substrate according to claim 1,
wherein the sublimation drying step is controlled such that T_{dp} and Tₘᵢₙ satisfy Tₘᵢₙ-T_{dp} ≥ 20.

3. The method for producing a substrate according to claim 1 or 2,
wherein, when a final surface temperature of the film during the coagulation process, in which the surface temperature increases after reaching the minimum temperature and stops increasing, is Tᵤₚ°C, the sublimation drying step is controlled such that T_{dp} and Tᵤₚ satisfy Tᵤₚ > T_{dp.}

4. The method for producing a substrate according to any one of claims 1 to 3, the method further comprising:
one or two or more treatments selected from the group consisting of a treatment for supplying a dry gas into an interior of the chamber or replacing a gas in the interior of the chamber with the dry gas in a step before the supply step, a treatment for bringing the dry gas into contact with the surface of the film in the sublimation drying step, and a treatment for heating the substrate in the sublimation drying step.

5. The method for producing a substrate according to any one of claims 1 to 4,
wherein the sublimation drying step includes, at least during the coagulation process of the film, a treatment for supplying a dry gas into an interior of the chamber and discharging a gas in the interior of the chamber.

6. The method for producing a substrate according to claim 4 or 5,
wherein the dry gas includes a dry inert gas.

7. The method for producing a substrate according to any one of claims 1 to 6,
wherein the sublimable film formation composition is supplied in the supply step and the sublimable film formation composition includes the sublimable substance and a solvent.

8. The method for producing a substrate according to claim 7,
wherein the sublimable film formation composition includes a solvent A1 for which a saturation solubility of the sublimable substance is more than 10% by mass and which has a boiling point lower than a boiling point of the sublimable substance at 1 atm by 5°C or more.

9. The method for producing a substrate according to claim 7,
wherein the sublimable film formation composition includes a solvent A2 for which a saturation solubility of the sublimable substance is more than 10% by mass, and
a solvent B2 for which a content in the sublimable film formation composition is greater than a content of the solvent A2 and which has a boiling point lower than a boiling point of the sublimable substance at 1 atm and lower than a boiling point of the solvent A2.

10. The method for producing a substrate according to any one of claims 1 to 9,
wherein a coagulation heat of the sublimable substance is 200 J/g or less.

11. The method for producing a substrate according to any one of claims 1 to 10,
wherein the cleaning liquid includes an alcohol with 3 or fewer carbon atoms.

12. The method for producing a substrate according to any one of claims 1 to 11,
wherein the substrate has the uneven structure having a pattern dimension of 30 nm or less on the surface.

13. The method for producing a substrate according to claim 12,
wherein the substrate has the uneven structure having the pattern dimension of 20 nm or less on the surface.

14. The method for producing a substrate according to any one of claims 1 to 13,
wherein the sublimable film formation composition does not contain water or contains a water content of 10% by mass or less with respect to 100% by mass of the sublimable substance.

15. A sublimation drying method comprising:
a sublimation drying step of coagulating, sublimating, and thereby removing a film formed of a sublimable substance or a sublimable film formation composition including a sublimable substance,
wherein, when a dew point temperature of an atmosphere in a vicinity of the film at 1 atm is T_{dp}°C and a minimum temperature of a surface of the film during a coagulation process is Tₘᵢₙ°C, the sublimation drying step is controlled such that T_{dp} and Tₘᵢₙ satisfy Tₘᵢₙ > T_{dp} .
